# EUROPÄISCHE PATENTSCHRIFT

(11) **EP 0 863 692 B1**
(45) Veröffentlichungstag und Bekanntmachung des Hinweises auf die Patenterteilung: **20.10.2004**
(21) Anmeldenummer: 98103872.2
(22) Anmeldetag: 05.03.1998
(51) Int. Cl.: H05K 7/14, H05K 5/02, H02B 1/052, H02B 1/46

(54) **Elektrisches Gerät**
Electrical apparatus
Appareil électrique

(30) Priorität: 07.03.1997 DE 19709554
(43) Veröffentlichungstag der Anmeldung: 09.09.1998
(73) Patentinhaber: HONEYWELL AG, 63067 Offenbach am Main (DE)
(72) Erfinder: Bayer, Dieter, Dipl.-Ing., 71032 Böblingen (DE); Hinkelmann, Horst, 71101 Schönaich (DE); Walter, Achim, Dipl.-Ing., 75446 Wiernsheim (DE); Maier, Dieter, 71093 Weil i. Schönbuch (DE)
(74) Vertreter: Leson, Thomas Johannes Alois, Dipl.-Ing.

(56) Entgegenhaltungen:
- EP-A- 0 702 441
- US-A- 4 816 966

## Beschreibung

Die vorliegende Erfindung bezieht sich auf ein elektrisches Gerät nach dem Gattungsbegriff des Patentanspruches 1.

Ein gerät gemäß dem Oberbegriff des Anspruchs 1 wird in EP-A-0 702 441 gezeigt.

Derartige Geräte finden insbesondere Anwendung als Regelgeräte, wobei es Regelgeräte gibt, die mit einer Bedieneroberfläche für die Eingabe und Anzeige von Daten versehen sind und die in einem entsprechenden Ausschnitt in der Fronttüre eines Schaltschrankes oder einer Wand eingesetzt werden und wobei es andererseits Regelgeräte gibt, die mit oder ohne ein solches Bedienteil direkt auf einer Wand montiert werden.

Aufgabe der vorliegenden Erfindung ist es, ein Regelgerät so auszugestalten, daß es bei gleichem Grundgehäuse bzw. Unterteil für beide Montagearten verwendbar ist.

Die Lösung dieser Aufgabe gelingt gemäß den kennzeichnenden Merkmalen des Patentanspruches 1. Weitere vorteilhafte Ausgestaltungen des erfindungsgemäßen Gerätes sind den abhängigen Ansprüchen entnehmbar.

Anhand der Figuren der beiliegenden Zeichnung sei im folgenden ein Ausführungsbeispiel der Erfindung näher beschrieben. Es zeigen:
- Fig. 1: ein Unterteil eines Reglergehäuses;
- Fig. 2: ein Bedienteil als Oberteil eines Reglergehäuses;
- Fig. 3: ein Befestigungsteil als Oberteil eines Reglergehäuses;
- Fig. 4: einen mit dem Befestigungsteil verbindbaren Montageclip in verschiedenen Ansichten;
- Fig. 5: den Einbau eines mit dem Bedienteil versehenen Unterteiles in einen Wandausschnitt; und
- Fig. 6: die Anbringung eines mit dem Befestigungsteil versehenen Unterteiles auf einer Montagewand; und
- Fig. 7: die Befestigung des mit Bedienteil versehenen Unterteiles auf einer Montagewand.

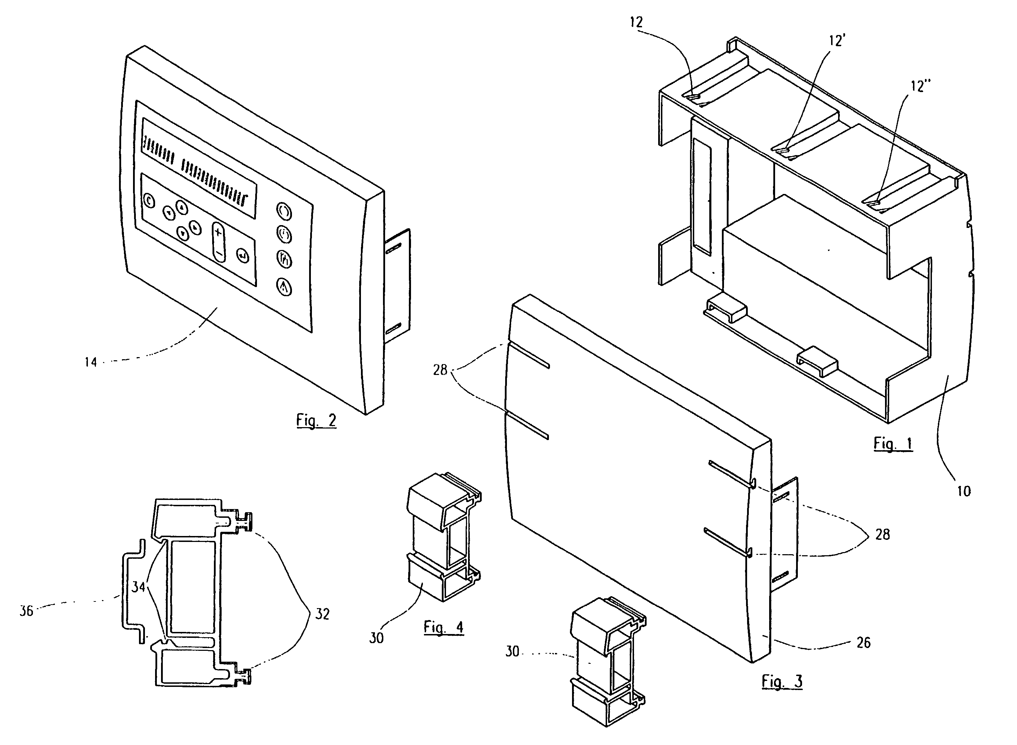

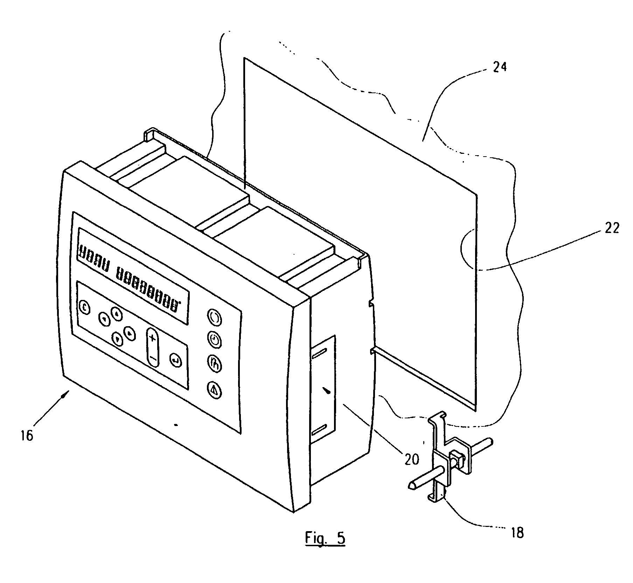

Figur 1 zeigt einen quaderförmigen Gehäuse-Unterteil 10, der Rastelemente 12, 12', 12" aufweist, die mit einem Oberteil zusammenwirken können, um beide Teile miteinander zu verbinden. Als ein Oberteil wird üblicherweise ein mit Eingabe- und Anzeigeelementen versehener Bedienteil 14 gemäß Figur 2 mit dem Unterteil 10 verrastet. Der auf diese Weise gebildete Regler 16 wird gemäß Figur 5 über Montagewinkel 18 und Befestigungslaschen 20 am Regler 16 in dem Ausschnitt 22 einer Wand 24 befestigt, wobei die Wand 24 z.B. durch die Fronttür eines Schrankes vorgegeben sein kann.

Andererseits gibt es Anwendungsfälle, bei denen auf eine Handeingabe und Anzeige verzichtet wird und bei denen der Regler auf einer Wand zu montieren ist. In diesem Fall wird ein Befestigungsteil 26 gemäß Figur 3 mit dem Unterteil 10 verrastet. Der Befestigungsteil 26 weist in seiner Oberfläche parallel zueinander verlaufende Nuten 28 auf, die nach der Seite des Befestigungsteiles 26 offen sind. In diese Nuten 28 können Montageclips 30 eingesetzt werden, wie sie in Figur 4 gezeigt sind. Die Montageclips 30 besitzen Füße 32 nach Art von Schienen, mit denen sie in die Nuten 28 eingreifen. An den Montageclips 30 ist ferner eine Führungsnut 34 angeordnet, über die die Montageclips auf eine Normschiene 36 aufsetzbar sind.

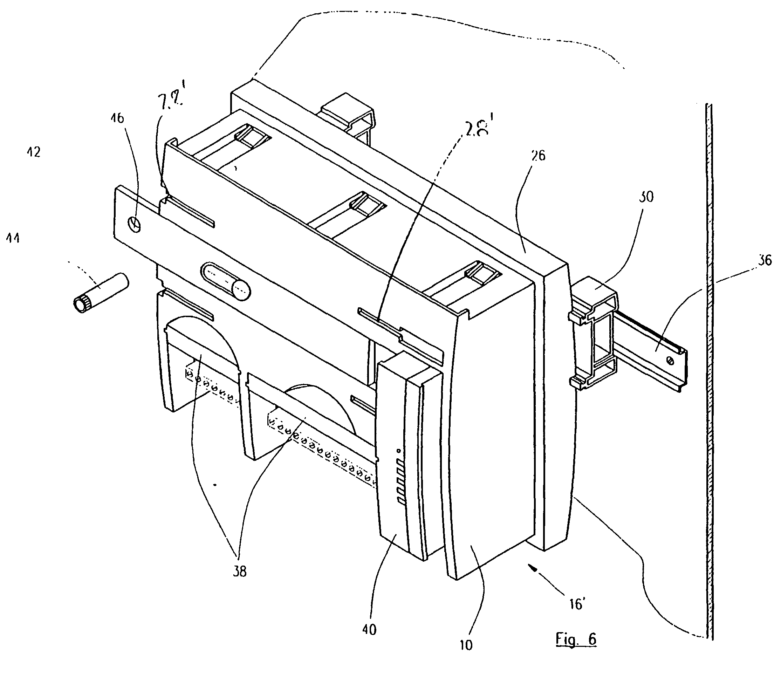

Die Normschiene 36 ist gemäß Figur 6 an der Wand 24 befestigt, so daß beim Eingriff der Montageclips 30 in die Normschiene 36 der Befestigungsteil 26 der Wand 24 zugekehrt ist und die Rückseite des Reglers 16' zur Vorderseite wird. Auf diese Weise werden Verdrahtungsklemmen 38 und ein Applikationsmodul 40 an dem nunmehr die Vorderseite des Reglers bildenden Unterteil 10 zugänglich.

Der Applikationsmodul 40 kann in der eingesetzten Stellung über einen Schieber 42 gesichert werden, wobei eine Sicherung 44 durch eine entsprechende Ausnehmung 46 in dem Schieber 42 und in dem Gehäuse-Unterteil 10 greift. Auf diese Weise kann der Applikationsmodul 40 nur aus dem Gehäuse 10 herausgenommen werden. nachdem die Sicherung 44 entfernt und der Schieber 42 aus seiner Raststellung mit dem Applikationsmodul 40 verschoben ist.

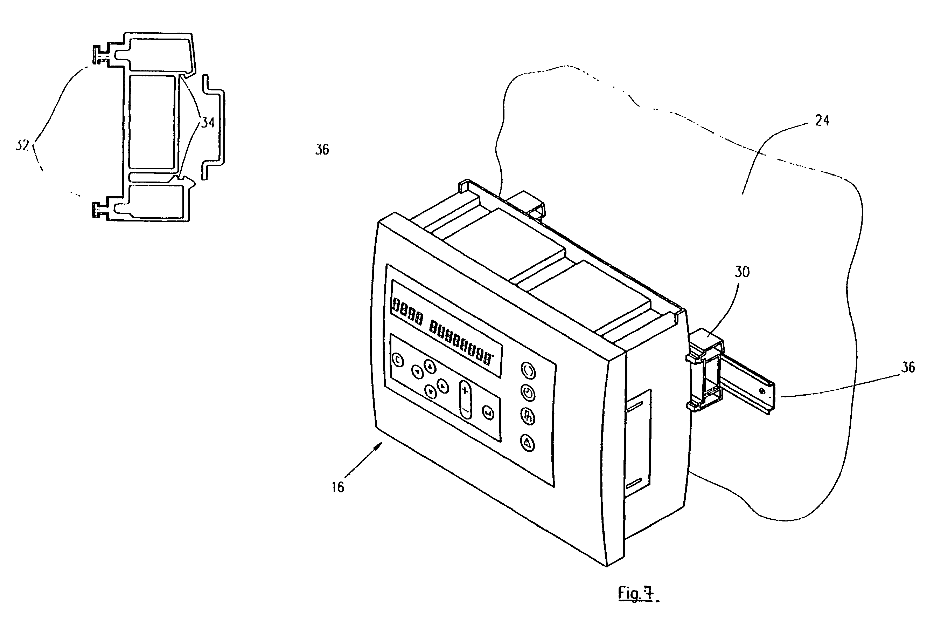

Gemäß Fig. 7 kann der mit Bedienteil versehene Regler 16 ebenfalls mittels der Montageclips 30 an der Normschiene 36 befestigt werden. Zu diesem Zweck ist der Unterteil 10 an seiner Rückwand, wie am besten aus Fig. 6 ersichtlich, ebenfalls mit seitlich offenen Nuten 28' versehen, in die die Montageclips 30 eingeschoben werden können. Die Nuten 28 sind dabei im gleichen vertikalen Abstand und Raster wie die Nuten 28 in dem Befestigungsteil 26 angeordnet.

## Patentansprüche

1. Elektrisches Gerät, insbesondere elektronischer Regler mit einem aus Unterteil und Oberteil bestehenden Gehäuse, wobei das Oberteil (14,26) mit dem Unterteil (10) verrastbar ist, **dadurch gekennzeichnet, daß** das Oberteil wahlweise aus einem Bedienteil (14) bei Einbau des Geräts in einen entsprechenden Ausschnitt einer Wand oder Tür oder aus einem Befestigungsteil (26) bei direkter Montage auf einer Wand besteht.

2. Elektrisches Gerät nach Anspruch 1, **dadurch gekennzeichnet, daß** das Befestigungsteil (26) mit Nuten (28) zur Aufnahme von Montageclips (30) versehen ist, die ihrerseits auf eine Normschiene (36) auf einer Wand (24) aufsetzbar sind.

3. Elektrisches Gerät nach Anspruch 1, **dadurch gekennzeichnet, daß** das Unterteil (10) eine Rückwand aufweist, die mit Nuten (28') zur Aufnahme von Montageclips (30) versehen ist, die ihrerseits auf eine Normschiene (36) auf einer Wand (24) aufsetzbar sind.

4. Elektrisches Gerät nach Anspruch 2 und 3, **dadurch gekennzeichnet, daß** die Nuten (28,28') in dem Befestigungsteil (26) und der Rückwand in gleichem vertikalen Abstand zur Aufnahme gleicher Montageclips (30) angeordnet sind.

5. Elektrisches Gerät nach Anspruch 1, **dadurch gekennzeichnet, daß** bei einem Bedienteil (14) als Oberteil das Gerät über Montagewinkel (18) und Laschen (20) in einen Ausschnitt (22) einer Wand (24) oder Tür eingebaut ist.

## Claims

1. Electrical apparatus, in particular an electronic control unit, with a casing consisting of a bottom part and a top part, the top part (14.26) being snap-fastenable to the bottom part (10), **characterized in that** the top part optionally consists of either a control panel (14) where the apparatus is to be fitted into a corresponding recess in a wall or door, or an attachment part (26) for direct mounting on a wall.

2. Electrical apparatus according to Claim 1, **characterized in that** the attachment part (26) is provided with grooves (28) to receive mounting clips (30) that are mountable in turn on a standard rail (36) on a wall (24).

3. Electrical apparatus according to Claim 1, **characterized in that** the bottom part (10) has a rear wall which is provided with grooves (28') to receive mounting clips (30) that are mountable in turn on a standard rail (36) on a wall (24).

4. Electrical apparatus according to Claims 2 and 3, **characterized in that** the grooves (28.28') in the attachment part (26) and rear wall are spaced apart at the same vertical distance, to receive the same mounting dips (30).

5. Electrical apparatus according to Claim 1, **characterized in that**, in the version with control panel (14) as top part, the apparatus is fitted with the aid of mounting brackets (18) and tongues (20) into a recess (22) in a wall (24) or door.

## Revendications

1. Appareil électrique, en particulier régulateur électronique comprenant un boîtier composé d'un élément inférieur et d'un élément supérieur, l'élément supérieur (14, 26) étant apte à être encliqueté avec l'élément inférieur (10), **caractérisé en ce que** l'élément supérieur se compose au choix d'un élément de commande (14) dans le cas du montage de l'appareil dans une découpe appropriée d'une paroi ou d'une porte, ou d'un élément de fixation (26) dans le cas d'un montage direct sur une paroi.

2. Appareil électrique selon la revendication 1, **caractérisé en ce que** l'élément de fixation (26) est pourvu de rainures (28) destinées à recevoir des attaches de montage (30) qui sont elles-mêmes aptes à être posées sur un rail normalisé (36) prévu sur une paroi (24).

3. Appareil électrique selon la revendication 1, **caractérisé en ce que** l'élément inférieur (10) présente une paroi arrière qui est pourvue de rainures (28') destinées à recevoir des attaches de montage (30) qui sont elles-mêmes aptes à être posées sur un rail normalisé (36) prévu sur une paroi (24).

4. Appareil électrique selon les revendications 2 et 3, **caractérisé en ce que** les rainures (28, 28') prévues dans l'élément de fixation (26) et dans la paroi arrière sont disposées avec le même écartement vertical afin de recevoir des attaches de montage (30) identiques.

5. Appareil électrique selon la revendication 1, **caractérisé en ce que** si l'élément supérieur est constitué par un élément de commande (14), l'appareil est monté dans une découpe (22) d'une paroi (24) ou d'une porte à l'aide de cornières de montage (18) et de pattes (20).
